# EUROPEAN PATENT APPLICATION

(11) **EP 4 818 722 A1**
(43) Date of publication of application: **07.10.2026**
(21) Application number: 26168168.8
(22) Date of filing: 26.03.2026
(51) Int. Cl.: G01R 31/389, G01R 31/36, G01R 31/392

(54) **MEASURE OF A BATTERY IMPEDANCE**

(30) Priority: 01.04.2025 FR 2503388
(71) Applicant: STMicroelectronics International N.V., 1228 Plan-les-Ouates, Geneva (CH)
(72) Inventor: BONACCORSO, Filippo, 95013 FIUMEFREDDO DI SICILIA (CT) (IT); BRANCIFORTE, Marco Maria, 95128 CATANIA (IT)
(74) Representative: Cabinet Beaumont

(57) **Abstract**

The present disclosure relates to a method for measuring the impedance of a battery comprising the following steps:
- applying (201) to said battery a first current;
- collecting in response a first voltage and a second current at the terminals of the battery;
- selecting (203) four first points of the first voltage with a time difference of a duration;
- selecting (203) four first points of the second current with a time difference of the duration;
- obtaining (204) first values by applying a function to said four first points and to said four first points, said function being the sum of three Dirac functions;
- determining (206) a first amplitude of said first voltage and a second amplitude of said second current based on several equations using said function and first values; and
- determining (207) said impedance based on said first and second amplitudes.

## Description

### Technical field

The present disclosure relates generally to electronic systems and electronic devices. The present concerns, more particularly, the measurement of features of basic electronic devices, such as the measurement of the impedance of a battery.

### Background art

Measuring the impedance of a battery is a good way to estimate its state of health and/or its inner cell temperature. Several methods for measuring the impedance of a battery exist nowadays.

It would be desirable to at least partly improve certain aspects of methods for measuring the impedance of a battery and electronic adapted to execute these methods.

### Summary of Invention

There is a need for more precise methods for measuring the impedance of a battery.

There is a need for less energy consuming methods for measuring the impedance of a battery.

There is a need for electronic devices capable of executing such method.

One embodiment addresses all or some of the drawbacks of known methods for measuring the impedance of a battery.

One embodiment addresses all or some of the drawbacks of known electronic devices used for measuring the impedance of a battery.

One embodiment provides a method for measuring the impedance of a battery, using an electronic device, comprising the following steps:
- applying to said battery a first sinusoidal current having a first time period;
- collecting in response a first sinusoidal voltage and a second sinusoidal current at the terminal of the battery;
- selecting at least four first points of the first sinusoidal voltage with a time difference of a first duration, wherein, if said first duration is lower than the first time period, said first duration being equal to the first time period divided by four, or if said first duration is greater than the first time period, said first duration being equal to the sum of said first time period divided by four and a multiple of said first time period;
- selecting at least four second points of the second sinusoidal current with a time difference of the first duration;
- obtaining first values by applying a first function to said at least four first points and to said at least four second points, said first function being the sum of three Dirac functions;
- determining a first amplitude of said first sinusoidal voltage and a second amplitude of said second sinusoidal current based on at least one system of equations using said first function and said first values; and
- determining the impedance of said battery based on said first amplitude and second amplitude.

Another embodiment provides an electronic device for measuring the impedance of a battery adapted to execute a method comprising the following steps:
- applying to said battery a first sinusoidal current having a first time period;
- collecting in response a first sinusoidal voltage and a second sinusoidal current at the terminal of the battery;
- selecting at least four first points of the first sinusoidal voltage with a time difference of a first duration, wherein, if said first duration is lower than the first time period, said first duration being equal to the first time period divided by four, or if said first duration is greater than the first time period, said first duration being equal to the sum of said first time period divided by four and a multiple of said first time period;
- selecting at least four second points of the second sinusoidal current with a time difference of the first duration;
- obtaining first values by applying a first function to said at least four first points and to said at least four second points, said first function being the sum of three Dirac functions;
- determining a first amplitude of said first sinusoidal voltage and a second amplitude of said second sinusoidal current based on at least one system of equations using said first function and said first values; and
- determining the impedance of said battery based on said first amplitude and second amplitude.

According to an embodiment, said at least one system of equations is also used for determining a first phase of said first sinusoidal voltage and a second phase of said second sinusoidal current, and a third phase of the battery is determined by used said first phase and said second phase.

According to an embodiment, said at least one system of equations is also used for determining a first offset of said first sinusoidal voltage and a second offset of said second sinusoidal current.

According to an embodiment, said first function is given by the following mathematical expression: [Math 1] $Delta \left(t\right) = {δ}_{t} + {δ}_{t + \frac{π}{2}} + {δ}_{t + \frac{3 π}{2}}$ wherein:
- Delta represents said first function; and
- *δₜ* represents a Dirac function.

According to an embodiment, said at least one system of equations is given by the following mathematical expression: [Math 2] $\left\{\begin{matrix}\left\{\begin{matrix}Delta \left(0\right) ∗ V \left(0\right) = V \left({t}_{rand}\right) + V \left({t}_{rand}+\frac{T}{4}\right) + V \left({t}_{rand}+\frac{T}{2}\right) \\ Delta \left(\frac{π}{2}\right) ∗ V \left(\frac{π}{2}\right) = V \left({t}_{rand}+\frac{T}{4}\right) + V \left({t}_{rand}+\frac{T}{2}\right) + V \left({t}_{rand}+\frac{3 T}{4}\right) \\ Delta \left(π\right) ∗ V \left(π\right) = V \left({t}_{rand}+\frac{T}{2}\right) + V \left({t}_{rand}+\frac{3 T}{4}\right) + V \left({t}_{rand}+T\right) \\ Delta \left(\frac{3 π}{2}\right) ∗ V \left(\frac{3 π}{2}\right) = V \left({t}_{rand}+\frac{3 T}{4}\right) + V \left({t}_{rand}+T\right) + V \left({t}_{rand}+\frac{5 T}{4}\right)\end{matrix}\right. \\ \left\{\begin{matrix}Delta \left(0\right) ∗ I \left(0\right) = I \left({t}_{rand}\right) + I \left({t}_{rand}+\frac{T}{4}\right) + I \left({t}_{rand}+\frac{T}{2}\right) \\ Delta \left(\frac{π}{2}\right) ∗ I \left(\frac{π}{2}\right) = I \left({t}_{rand}+\frac{T}{4}\right) + I \left({t}_{rand}+\frac{T}{2}\right) + I \left({t}_{rand}+\frac{3 T}{4}\right) \\ Delta \left(π\right) ∗ I \left(π\right) = I \left({t}_{rand}+\frac{T}{2}\right) + I \left({t}_{rand}+\frac{3 T}{4}\right) + I \left({t}_{rand}+T\right) \\ Delta \left(\frac{3 π}{2}\right) ∗ I \left(\frac{3 π}{2}\right) = I \left({t}_{rand}+\frac{3 T}{4}\right) + I \left({t}_{rand}+T\right) + I \left({t}_{rand}+\frac{5 T}{4}\right)\end{matrix}\right.\end{matrix}\right.$ wherein:
- Delta represents said first function;
- V(t) represents said first sinusoidal voltage;
- I(t) represents said second sinusoidal current;
- *t_{rand}* represents a random time wherein a first of the at least first and second four points is taken; and
- T represents said first time period.

According to an embodiment, said first values are filtered before being used in said system of equations.

According to an embodiment, said first values are filtered by using a low pass filter.

According to an embodiment, several system of equations are used for determining said first amplitude and second amplitude.

According to an embodiment, said electronic device comprises a first circuit adapted to apply said first sinusoidal current to said battery.

According to an embodiment, said electronic device comprises a second circuit adapted to sense said first sinusoidal voltage to said battery.

According to an embodiment, said electronic device comprises a third circuit adapted to sense said second sinusoidal current to said battery.

Another embodiment provides a system comprising an electronic device previously described, and a battery.

### Brief description of drawings

The foregoing features and advantages, as well as others, will be described in detail in the following description of specific embodiments given by way of illustration and not limitation with reference to the accompanying drawings, in which:
Figure 1 illustrates an embodiment of an electronic device used for measuring the impedance of a battery ; and
Figure 2 illustrates an embodiment of a method for measuring the impedance of a battery.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 %, and preferably within 5 %.

The above described embodiments concerns a method for measuring of the impedance of a battery, and an electronic device for executing this method. This method comprises the application of a sinusoidal stimulus signal to the battery and collecting the sinusoidal voltage response and the sinusoidal current response of the battery. Four points are then each extracted from the sinusoidal voltage response and the sinusoidal current response and used in a system of equation for determining the phase of the voltage and current response of the battery. An impedance is then calculated.

Moreover, the above described embodiments are particularly adapted to be used in any kind of industrial markets where a voltage conversion is necessary. More particularly, such voltage converter circuit can be intended for:
- the automotive industry, for example in the domain of car electrification or the domain of advanced driver assistance systems (ADAS);
- the industrial industry, for example in the domain of green energy, in the domain of electrification of infrastructure, of the internet of things (IoT), and of smart homes, wherein power and energy consumption and the exchange of data are key element;
- the personal electronics industry, for example in the domain of mobile phone and of the internet of things (IoT), and in the domain of high speed-interface; and
- the communications equipment, computers and peripherals industry, for example in the domain of infrastructure and data centers, and in the domain of satellites in low earth orbit.

Moreover, the above described embodiments are particularly adapted to being used in every electronic device using a battery and needing to monitor the impedance of this battery, such as Battery Energy Storage Systems (BESS). According to an example, these embodiments may be used in battery powered equipment, like battery powered tools, such as cleaning tools or gardening tools, or battery powered vehicle, such as electric bikes, etc.

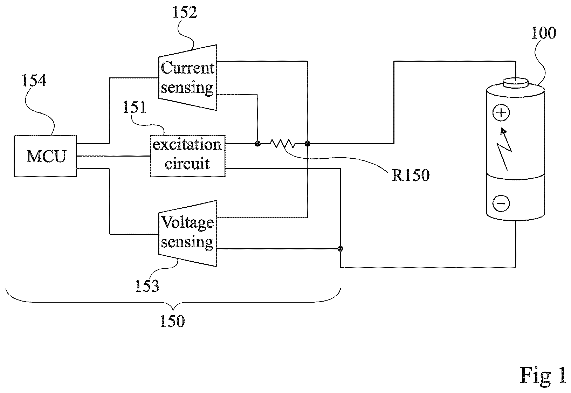

Figure 1 represents, very schematically, an embodiment of an electronic device 150 used for measuring the impedance of a battery 100.

Battery 100 comprises two terminals represented by symbol "+" and "-" in figure 1. According to an example, battery 100 may be of any type of battery type known by the person skilled in the art. According to a preferred example, battery 100 is a Lithium-Ion-type battery.

According to an embodiment, electronic device 150 comprises an excitation circuit 151 (excitation circuit) coupled between the two terminals of the battery. This excitation circuit 151 is capable of providing a sinusoidal stimulus to the battery 100, and more particularly a sinusoidal current stimulus to the battery 100.

According to an embodiment, electronic device 150 further comprises a resistor R150 coupled between the excitation circuit 151 and one of the terminal of the battery 100. In the example of figure 1, resistor R150 is coupled between the terminal + of the battery and the excitation circuit 151.

According to an embodiment, electronic device 150 further comprises a current sensing circuit 152 (Current sensing) adapted to sense, or collect, the current response of the battery 100. According an example, current sensing circuit 152 senses this current response by sensing the current through the resistor R150.

According to an embodiment, electronic device 150 further comprises a voltage sensing circuit 153 (Voltage sensing) adapted to sense, or collect, the voltage response of the battery 100. According an example, voltage sensing circuit 153 senses this voltage response by sensing the voltage at the terminal of resistor R150.

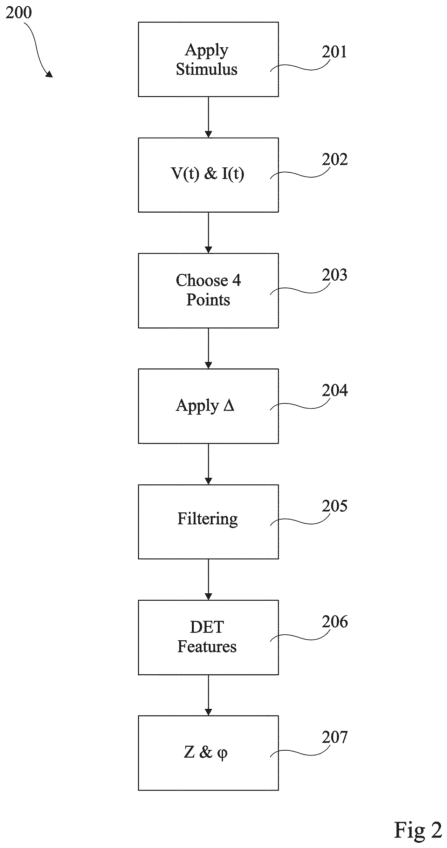

According to an embodiment, electronic device 150 may further comprise a control circuit 154 (MCU) of the circuits 151, 152 and 153. This control circuit 154 is capable of measuring the impedance of the battery based on the current and voltage response sensed by circuit 152 and 153 by using a method described in relation with figure 2. This control circuit 154 may be a processor, a microprocessor, a controller, a microcontroller, or any control circuit accessible to the person skilled in the art.

Figure 2 is a block diagram illustrating an example of an embodiment of a method 200 for measuring the impedance of a battery. According to an example, method 200 is executed by an electronic device such as electronic device 150 described in relation with figure 1.

At an initial step 201 (Apply Stimulus), a battery, such as battery 100 described in relation with figure 1, is coupled to an electronic device of the type of device 150 of figure 1. A sinusoidal stimulus signal is applied between the terminals of the battery. According to an embodiment, the sinusoidal stimulus signal is a sinusoidal current Istimulus(t). A model considered here of the sinusoidal current Istimulus(t) is given by the following mathematical equation: [Math 3] $Istimulus \left(t\right) = {I}_{St 0 } sin \left(\frac{2 πt}{{T}_{st}}+{φ}_{st}\right) + {I}_{st 1}$ wherein:
- *I*_{*St*0} represents the amplitude of sinusoidal current Istimulus(t);
- *Tₛₜ* represents the time period of sinusoidal current Istimulus(t);
- *φₛₜ* represents the phase of sinusoidal current Istimulus(t); and
- *I*_{*St*1} represents the amplitude of sinusoidal current Istimulus(t).

According to an example, this step 201 is executed by an excitation circuit such as excitation circuit 151 of figure 1.

At a step 202 (V(t) & I(t)), following, for example directly, step 201, the voltage response V(t) and the current response I(t) of the battery is sensed, or collected, by the electronic device. Both of these responses are sinusoidal signal. A model considered here of the sinusoidal current response I(t) is given by the following mathematical equation: [Math 4] $I \left(t\right) = {I}_{0} sin \left(\frac{2 πt}{{T}_{i}}+{φ}_{i}\right) + {I}_{1}$ wherein:
- *I*₀ represents the amplitude of sinusoidal current response I(t);
- *Tᵢ* represents the time period of sinusoidal current response I(t);
- *φᵢ* represents the phase of sinusoidal current response I(t); and
- *I*₁ represents the amplitude of sinusoidal current response I(t).

A model considered here of the sinusoidal voltage response V(t) is given by the following mathematical equation: [Math 5] $V \left(t\right) = {V}_{0} sin \left(\frac{2 πt}{{T}_{v}}+{φ}_{v}\right) + {V}_{1}$ wherein:
- *I*₀ represents the amplitude of sinusoidal voltage response V(t);
- *Tᵥ* represents the time period of sinusoidal voltage response V(t);
- *φᵥ* represents the phase of sinusoidal voltage response V(t); and
- *V*₁ represents the amplitude of sinusoidal voltage response V(t).

According to an embodiment, time periods *Tₛₜ, Tᵢ,* and *Tᵥ* are all equal to each other and to a common time period T.

According to an example, this step 202 is executed by a current sensing circuit such as current sensing circuit 152 of figure 1 and by a voltage sensing circuit such as current sensing circuit 153 of figure 1.

At a step 203 (Choose 4 points), following, for example directly, step 202, both the voltage response and the current response of the battery are sampled, and at least four points are selected in each response. According to an embodiment, for each response, the four selected points are all separated from the same time difference referenced as duration Tsample also called a sampling frequency Tsample. According to an example, a multiple of four points are selected in each response.

According to first case, if duration Tsample is lower than or equal to the time period T, then duration Tsample is equal to the time period T divided by four. In other words, in this case, duration Tsample is given by the following mathematical equation: [Math 6] $Tsample = \frac{T}{4}$

According to second case, if duration Tsample is greater than the time period T, then duration Tsample is equal to the sum of time period T divided by four and a multiple of time period T. In other words, in the case, duration Tsample is given by the following mathematical equation: [Math 7] $Tsample = \frac{T}{4} + n ∗ T$ wherein n is an integer greater than or equal to one.

Concerning the voltage response V(t), and considering the case wherein Tsample is lower than or equal to T, the values of the voltage for the at least four points PV(1), PV(2), PV(3) and PV(4) are given by the following mathematical equations: [Math 8] $\left\{\begin{matrix}PV \left(1\right) = > V \left({t}_{rand}\right) \\ PV \left(2\right) = > V \left({t}_{rand}+\frac{T}{4}\right) \\ PV \left(3\right) = > V \left({t}_{rand}+\frac{T}{2}\right) \\ PV \left(4\right) = > V \left({t}_{rand}+\frac{3 T}{4}\right)\end{matrix}\right.$ wherein *t_{rand}* is a random time wherein a first of the at least four points is taken.

Concerning the current response I(t), and considering the case wherein Tsample is lower than or equal to T, the values of the current for the at least four points PI(1), PI(2), PI(3) and PI(4) are given by the following mathematical equations: [Math 9] $\left\{\begin{matrix}PI \left(1\right) = > I \left({t}_{rand}\right) \\ PI \left(2\right) = > I \left({t}_{rand}+\frac{T}{4}\right) \\ PI \left(3\right) = > I \left({t}_{rand}+\frac{T}{2}\right) \\ PI \left(4\right) = > I \left({t}_{rand}+\frac{3 T}{4}\right)\end{matrix}\right.$

According to an example, this step 203 is executed by a current sensing circuit such as current sensing circuit 152 of figure 1 and by a voltage sensing circuit such as current sensing circuit 153 of figure 1. According to another example, this step 202 is executed by a control circuit such as control circuit 154 of Figure 1.

At a step 204 (Apply Δ), following, for example directly, step 203, a function Delta, or function Δ, is defined by the following mathematical expression: [Math 10] $Delta \left(x\right) = δ \left(x\right) + δ \left(x+\frac{π}{2}\right) + δ \left(x+\frac{3 π}{2}\right)$ wherein *δ*(*x*) represent the image of a value x by of well-known Dirac function.

This function Delta is applied to each point selected at step 203.

Concerning the voltage response V(t), function Delta is applied to each point PV(1) , PV(2), PV(3) and PV(4), and four mathematical expressions are obtained: [Math 11] $\left\{\begin{matrix}Delta \left(0\right) ∗ V \left(0\right) = {V}_{0} cos \left({φ}_{v}\right) + 3 ∗ {V}_{1} \\ Delta \left(\frac{π}{2}\right) ∗ V \left(\frac{π}{2}\right) = - {V}_{0} sin \left({φ}_{v}\right) + 3 ∗ {V}_{1} \\ Delta \left(π\right) ∗ V \left(π\right) = - {V}_{0} cos \left({φ}_{v}\right) + 3 ∗ {V}_{1} \\ Delta \left(\frac{3 π}{2}\right) ∗ V \left(\frac{3 π}{2}\right) = {V}_{0} sin \left({φ}_{v}\right) + 3 ∗ {V}_{1}\end{matrix}\right.$

Concerning the current response I(t), function Delta is applied to each point PI(1), PI(2), PI(3) and PI(4), and four mathematical expressions are obtained: [Math 12] $\left\{\begin{matrix}Delta \left(0\right) ∗ I \left(0\right) = {I}_{0} cos \left({φ}_{i}\right) + 3 ∗ {I}_{1} \\ Delta \left(\frac{π}{2}\right) ∗ I \left(\frac{π}{2}\right) = - {I}_{0} sin \left({φ}_{i}\right) + 3 ∗ {I}_{1} \\ Delta \left(π\right) ∗ I \left(π\right) = - {I}_{0} cos \left({φ}_{i}\right) + 3 ∗ {I}_{1} \\ Delta \left(\frac{3 π}{2}\right) ∗ I \left(\frac{3 π}{2}\right) = {I}_{0} sin \left({φ}_{i}\right) + 3 ∗ {I}_{1}\end{matrix}\right.$

According to an example, this step 204 is executed by a current sensing circuit such as current sensing circuit 152 of figure 1 and by a voltage sensing circuit such as current sensing circuit 153 of figure 1. According to another example, this step 202 is executed by a control circuit such as control circuit 154 of Figure 1.

At an optional step 205 (Filtering), following, for example directly, step 204, one or several filters may be applied to the values of function Delta calculated at step 204. According to one example, this filter may help to improve the accuracy of voltage response V(t) and current response I(t). According to one example, this filter may help to attenuate the noise of voltage response V(t) and current response I(t). According to one example, this filter may be a low pass filter.

According to an example, this step 205 is executed by a current sensing circuit such as current sensing circuit 152 of figure 1 and by a voltage sensing circuit such as current sensing circuit 153 of figure 1. According to another example, this step 202 is executed by a control circuit such as control circuit 154 of Figure 1.

At a step 206 (DET Features), following, for example directly, step 205, the amplitudes v₀ and i₀ of voltage response V(t) and current response I(t) are then determined by resolving a system of equations using the expressions of function Delta obtained at step 204, or at step 205 if this step if executed.

More particularly, concerning the voltage response V(t), it is easy to demonstrate the following mathematical equalities: [Math 13] $\left\{\begin{matrix}Delta \left(0\right) ∗ V \left(0\right) = V \left({t}_{rand}\right) + V \left({t}_{rand}+\frac{T}{4}\right) + V \left({t}_{rand}+\frac{T}{2}\right) \\ Delta \left(\frac{π}{2}\right) ∗ V \left(\frac{π}{2}\right) = V \left({t}_{rand}+\frac{T}{4}\right) + V \left({t}_{rand}+\frac{T}{2}\right) + V \left({t}_{rand}+\frac{3 T}{4}\right) \\ Delta \left(π\right) ∗ V \left(π\right) = V \left({t}_{rand}+\frac{T}{2}\right) + V \left({t}_{rand}+\frac{3 T}{4}\right) V \left({t}_{rand}+T\right) \\ Delta \left(\frac{3 π}{2}\right) ∗ V \left(\frac{3 π}{2}\right) = V \left({t}_{rand}+\frac{3 T}{4}\right) + V \left({t}_{rand}+T\right) + V \left({t}_{rand}+\frac{5 T}{4}\right)\end{matrix}\right.$

According to an embodiment, using the expression of function Delta obtained at step 204, this system of equations is easy to resolve in order to obtain amplitude v₀. According to an example, solving this system of equations yields the phase *φᵥ* and the offset v₁ of the voltage response V(t).

A first solution of this system of equations gives the following equalities: [Math 14] $\left\{\begin{matrix}{v}_{1} = \frac{V \left({t}_{rand}\right) + V \left({t}_{rand}+\frac{T}{2}\right)}{2} \\ {φ}_{v} = {tan}^{- 1} \left(\frac{V \left({t}_{rand}+\frac{T}{4}\right) - {v}_{1}}{V \left({t}_{rand}\right) - {v}_{1}}\right) \\ {v}_{0} = \frac{V \left({t}_{rand}\right) - V \left({t}_{rand}+\frac{T}{2}\right)}{2 cos \left({φ}_{v}\right)}\end{matrix}\right.$

A second solution of this system of equations gives the following equality: [Math 15] ${v}_{0}^{2} = {\left({v}_{0}cos\left(\frac{2 πt}{T}+{φ}_{v}\right)\right)}^{2} + {\left({v}_{0}sin\left(\frac{2 πt}{T}+{φ}_{v}\right)\right)}^{2}$

Very similarly, concerning the current response I(t), it is easy to demonstrate the following mathematical equalities: [Math 16] $\left\{\begin{matrix}Delta \left(0\right) ∗ I \left(0\right) = I \left({t}_{rand}\right) + I \left({t}_{rand}+\frac{T}{4}\right) + I \left({t}_{rand}+\frac{T}{2}\right) \\ Delta \left(\frac{π}{2}\right) ∗ I \left(\frac{π}{2}\right) = I \left({t}_{rand}+\frac{T}{4}\right) + I \left({t}_{rand}+\frac{T}{2}\right) + I \left({t}_{rand}+\frac{3 T}{4}\right) \\ Delta \left(π\right) ∗ I \left(π\right) = I \left({t}_{rand}+\frac{T}{2}\right) + I \left({t}_{rand}+\frac{3 T}{4}\right) I \left({t}_{rand}+T\right) \\ Delta \left(\frac{3 π}{2}\right) ∗ I \left(\frac{3 π}{2}\right) = I \left({t}_{rand}+\frac{3 T}{4}\right) + I \left({t}_{rand}+T\right) + I \left({t}_{rand}+\frac{5 T}{4}\right)\end{matrix}\right.$

According to an embodiment, using the expression of function Delta obtained at step 204, this system of equations is easy to resolve in order to obtain amplitude i₀. According to an example, solving this system of equations yields the phase *φᵢ* and the offset i₁ of the current response I(t).

A first solution of this system of equations gives the following equalities: [Math 17] $\left\{\begin{matrix}{i}_{1} = \frac{I \left({t}_{rand}\right) + I \left({t}_{rand}+\frac{T}{2}\right)}{2} \\ {φ}_{i} = {tan}^{- 1} \left(\frac{I \left({t}_{rand}+\frac{T}{4}\right) - {v}_{1}}{i \left({t}_{rand}\right) - {v}_{1}}\right) \\ {i}_{0} = \frac{I \left({t}_{rand}\right) - I \left({t}_{rand}+\frac{T}{2}\right)}{2 cos \left({φ}_{i}\right)}\end{matrix}\right.$

A second solution of this system of equations gives the following equality: [Math 18] ${vi}_{0}^{2} = {\left({i}_{0}cos\left(\frac{2 πt}{T}+{φ}_{i}\right)\right)}^{2} + {\left({i}_{0}sin\left(\frac{2 πt}{T}+{φ}_{i}\right)\right)}^{2}$

According to an example, this step 206 is executed by a control circuit such as control circuit 154 of Figure 1.

At a step 207 (Z & *φ*)*,* following, for example directly, step 206, the impedance Z of the battery is determined by applying the following mathematical operation: [Math 19] $Z = \frac{{v}_{0}}{{i}_{0}}$

According to an example, it is also possible to determine the phase *φ* of the batterie by applying the following mathematical operation: [Math 220] $φ = {φ}_{v} - {φ}_{i}$

According to an example, this step 207 is executed by a control circuit such as control circuit 154 of Figure 1.

Various embodiments and variants have been described. Those skilled in the art will understand that certain features of these embodiments can be combined and other variants will readily occur to those skilled in the art.

According to an embodiment, the method described in relation with figure 2 may be applied to a very large number, corresponding to a multiple of four, of at least four points in order to increase the accuracy of the measured impedance of the battery.

Finally, the practical implementation of the embodiments and variants described herein is within the capabilities of those skilled in the art based on the functional description provided hereinabove.

## Claims

1. Method for measuring the impedance of a battery, using an electronic device, comprising the following steps:
- applying (201) to said battery a first sinusoidal current (Istimulus(t)) having a first time period (T);
- collecting in response a first sinusoidal voltage (V(t)) and a second sinusoidal current (I(t)) at the terminals of the battery;
- selecting (203) at least four first points (PV(1), PV(2), PV(3), PV(4)) of the first sinusoidal voltage (V(t)) with a time difference of a first duration (Tsample), wherein, if said first duration (Tsample) is lower than the first time period (T), said first duration (Tsample) being equal to the first time period (T) divided by four, or if said first duration (Tsample) is greater than the first time period (T), said first duration (Tsample) being equal to the sum of said first time period (T) divided by four and a multiple of said first time period (T);
- selecting (203) at least four second points (PI(1), PI(2), PI(3), PI(4)) of the second sinusoidal current (I(t)) with a time difference of the first duration (Tsample);
- obtaining (204) first values (*V*(*t_{rand}*)*,* $V \left({t}_{rand}+\frac{T}{4}\right)$, $V \left({t}_{rand}+\frac{T}{2}\right) , V \left({t}_{rand}+\frac{3 T}{4}\right)$, *I*(*t_{rand}*), $I \left({t}_{rand}+\frac{T}{4}\right) , I \left({t}_{rand}+\frac{T}{2}\right)$*,* $I \left({t}_{rand}+\frac{3 T}{4}\right)$) by applying a first function (Delta) to said at least four first points (PV(1), PV(2), PV(3), PV(4)) and to said at least four second points (PI(1), PI(2), PI(3), PI(4)), said first function (Delta) being the sum of three Dirac functions (*δ*(*x*)*,* $δ \left(x+\frac{π}{2}\right) , δ \left(x+\frac{3 π}{2}\right)$);
- determining (206) a first amplitude (v₀) of said first sinusoidal voltage (V(t)) and a second amplitude (i₀) of said second sinusoidal current (V(t)) based on at least one system of equations using said first function (Delta) and said first values (*V*(*t_{rand}*)*,* $V \left({t}_{rand}+\frac{T}{4}\right) , V \left({t}_{rand}+\frac{T}{2}\right) , V \left({t}_{rand}+\frac{3 T}{4}\right)$ , *I*(*t_{rand}*)*,* $I \left({t}_{rand}+\frac{T}{4}\right) , I \left({t}_{rand}+\frac{T}{2}\right) , I \left({t}_{rand}+\frac{3 T}{4}\right)$); and
- determining (207) the impedance (Z) of said battery based on said first amplitude (v₀) and second amplitude (i₀).

2. Electronic device for measuring the impedance of a battery adapted to execute a method comprising the following steps:
- applying (201) to said battery a first sinusoidal current (Istimulus(t)) having a first time period (T);
- collecting in response a first sinusoidal voltage (V(t)) and a second sinusoidal current (I(t)) at the terminals of the battery;
- selecting (203) at least four first points (PV(1), PV(2), PV(3), PV(4)) of the first sinusoidal voltage (V(t)) with a time difference of a first duration (Tsample), wherein, if said first duration (Tsample) is lower than the first time period (T), said first duration (Tsample) being equal to the first time period (T) divided by four, or if said first duration (Tsample) is greater than the first time period (T), said first duration (Tsample) being equal to the sum of said first time period (T) divided by four and a multiple of said first time period (T);
- selecting (203) at least four second points (PI(1), PI(2), PI(3), PI(4)) of the second sinusoidal current (I(t)) with a time difference of the first duration (Tsample);
- obtaining (204) first values (*V*(*t_{rand}*), $V \left({t}_{rand}+\frac{T}{4}\right)$*,* $V \left({t}_{rand}+\frac{T}{2}\right) , V \left({t}_{rand}+\frac{3 T}{4}\right)$*, I*(*t_{rand}*), $I \left({t}_{rand}+\frac{T}{4}\right) , I \left({t}_{rand}+\frac{T}{2}\right)$*,* $I \left({t}_{rand}+\frac{3 T}{4}\right)$) by applying a first function (Delta) to said at least four first points (PV(1), PV(2), PV(3), PV(4)) and to said at least four second points (PI(1), PI(2), PI(3), PI(4)), said first function (Delta) being the sum of three Dirac functions (*δ*(*x*)*,* $δ \left(x+\frac{π}{2}\right) , δ \left(x+\frac{3 π}{2}\right)$);
- determining (206) a first amplitude (v₀) of said first sinusoidal voltage (V(t)) and a second amplitude (i₀) of said second sinusoidal current (V(t)) based on at least one system of equations using said first function (Delta) and said first values (*V*(*t_{rand}*)*,* $V \left({t}_{rand}+\frac{T}{4}\right) , V \left({t}_{rand}+\frac{T}{2}\right) , V \left({t}_{rand}+\frac{3 T}{4}\right)$ , *I*(*t_{rand}*)*,* $I \left({t}_{rand}+\frac{T}{4}\right) , I \left({t}_{rand}+\frac{T}{2}\right) , I \left({t}_{rand}+\frac{3 T}{4}\right)$); and
- determining (207) the impedance (Z) of said battery based on said first amplitude (v₀) and second amplitude (i₀).

3. Method according to claim 1, or device according to claim 2, wherein said at least one system of equations is also used for determining a first phase (*φᵥ*) of said first sinusoidal voltage (V(t)) and a second phase (*φᵢ*) of said second sinusoidal current (I(t)), and a third phase (*φ*) of the battery is determined by used said first phase (*φᵥ*) and said second phase (*φᵢ*)*.*

4. Method according to claim 1 or 3, or device according to claim 2 or 3, wherein said at least one system of equations is also used for determining a first offset (v₁) of said first sinusoidal voltage (V(t)) and a second offset (i₁) of said second sinusoidal current (I(t)).

5. Method according to any of claims 1, 3 or 4, or device according to any of claims 2 to 4, wherein said first function (Delta) is given by the following mathematical expression: [Math 21] $Delta \left(t\right) = {δ}_{t} + {δ}_{t + \frac{π}{2}} + {δ}_{t + \frac{3 π}{2}}$ wherein:
- Delta represents said first function; and
- *δₜ* represents a Dirac function.

6. Method or device according to claim 5, wherein said at least one system of equations is given by the following mathematical expression: [Math 22] $\left\{\begin{matrix}\left\{\begin{matrix}Delta \left(0\right) ∗ V \left(0\right) = V \left({t}_{rand}\right) + V \left({t}_{rand}+\frac{T}{4}\right) + V \left({t}_{rand}+\frac{T}{2}\right) \\ Delta \left(\frac{π}{2}\right) ∗ V \left(\frac{π}{2}\right) = V \left({t}_{rand}+\frac{T}{4}\right) + V \left({t}_{rand}+\frac{T}{2}\right) + V \left({t}_{rand}+\frac{3 T}{4}\right) \\ Deta \left(π\right) ∗ V \left(π\right) = V \left({t}_{rand}+\frac{T}{2}\right) + V \left({t}_{rand}+\frac{3 T}{4}\right) + V \left({t}_{rand}+T\right) \\ Delta \left(\frac{3 π}{2}\right) ∗ V \left(\frac{3 π}{2}\right) = V \left({t}_{rand}+\frac{3 T}{4}\right) + V \left({t}_{rand}+T\right) + V \left({t}_{rand}+\frac{5 T}{4}\right)\end{matrix}\right. \\ \left\{\begin{matrix}Delta \left(0\right) ∗ I \left(0\right) = I \left({t}_{rand}\right) + I \left({t}_{rand}+\frac{T}{4}\right) + I \left({t}_{rand}+\frac{T}{2}\right) \\ Delta \left(\frac{π}{2}\right) ∗ I \left(\frac{π}{2}\right) = I \left({t}_{rand}+\frac{T}{4}\right) + I \left({t}_{rand}+\frac{T}{2}\right) + I \left({t}_{rand}+\frac{3 T}{4}\right) \\ Delta \left(π\right) ∗ I \left(π\right) = I \left({t}_{rand}+\frac{T}{2}\right) + I \left({t}_{rand}+\frac{3 T}{4}\right) + I \left({t}_{rand}+T\right) \\ Delta \left(\frac{3 π}{2}\right) ∗ I \left(\frac{3 π}{2}\right) = I \left({t}_{rand}+\frac{3 T}{4}\right) + I \left({t}_{rand}+T\right) + I \left({t}_{rand}+\frac{5 T}{4}\right)\end{matrix}\right.\end{matrix}\right.$ wherein:
- Delta represents said first function (Delta);
- V(t) represents said first sinusoidal voltage (V(t));
- I(t) represents said second sinusoidal current (I(t));
- *t_{rand}* represents a random time wherein a first of the at least first and second four points (PV(1), PV(2), PV(3), PV(4), PI(1), PI(2), PI(3), PI(4)) is taken; and
- T represents said first time period.

7. Method according to any of claims 1, 3 to 6, or device according to any of claims 2 to 6, wherein said first values (*V*(*t_{rand}*), $V \left({t}_{rand}+\frac{T}{4}\right) , V \left({t}_{rand}+\frac{T}{2}\right) , V \left({t}_{rand}+\frac{3 T}{4}\right)$*, I*(*t_{rand}*)*,* $I \left({t}_{rand}+\frac{T}{4}\right) , I \left({t}_{rand}+\frac{T}{2}\right) , I \left({t}_{rand}+\frac{3 T}{4}\right)$) are filtered before being used in said system of equations.

8. Method or device according to claim 7, wherein said first values (*V*(*t_{rand}*)*,* $V \left({t}_{rand}+\frac{T}{4}\right) , V \left({t}_{rand}+\frac{T}{2}\right) , V \left({t}_{rand}+\frac{3 T}{4}\right)$*, I*(*t_{rand}*)*,* $I \left({t}_{rand}+\frac{T}{4}\right) , I \left({t}_{rand}+\frac{T}{2}\right) , I \left({t}_{rand}+\frac{3 T}{4}\right)$) are filtered by using a low pass filter.

9. Method according to any of claims 1, 3 to 8, or device according to any of claims 2 to 8, wherein several system of equations are used for determining said first amplitude (v₀) and second amplitude (i₀).

10. Method according to any of claims 1, 3 to 9, or device according to any of claims 2 to 9, wherein said electronic device comprises a first circuit (151) adapted to apply said first sinusoidal current (Istimulus(t)) to said battery.

11. Method according to any of claims 1, 3 to 10, or device according to any of claims 2 to 10, wherein said electronic device comprises a second circuit (153) adapted to sense said first sinusoidal voltage (V(t)) to said battery.

12. Method according to any of claims 1, 3 to 11, or device according to any of claims 2 to 11, wherein said electronic device comprises a third circuit (152) adapted to sense said second sinusoidal current (I(t)) to said battery.

13. System comprising an electronic device (150) according to any of claims 2 to 12, and a battery (100).
